(19) Europäisches Patentamt
European Patent Office
Office européen des brevets

(11) **EP 3 885 674 B1**

(12) **EUROPÄISCHE PATENTSCHRIFT**

(45) Veröffentlichungstag und Bekanntmachung des Hinweises auf die Patenterteilung:
**26.07.2023 Patentblatt 2023/30**

(21) Anmeldenummer: **21159047.6**

(22) Anmeldetag: **24.02.2021**

(51) Internationale Patentklassifikation (IPC):
*F25B 21/02* *(2006.01)*

(52) Gemeinsame Patentklassifikation (CPC):
**F25B 21/02; H10N 10/17; F25B 2321/023**

(54) **VORRICHTUNG ZUR KÄLTE- UND STROMERZEUGUNG NACH DEM PRINZIP VON PELTIER**

DEVICE FOR GENERATING COLD AND POWER ACCORDING TO THE PELTIER EFFECT

DISPOSITIF DE PRODUCTION DE FROID ET D'ÉLECTRICITÉ SELON LE PRINCIPE DE PELTIER

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.03.2020 DE 102020106024**

(43) Veröffentlichungstag der Anmeldung:
**29.09.2021 Patentblatt 2021/39**

(73) Patentinhaber: **Weißhaar, Peter**
**32108 Bad Salzuflen (DE)**

(72) Erfinder: **Weißhaar, Peter**
**32108 Bad Salzuflen (DE)**

(74) Vertreter: **Dantz, Jan Henning et al**
**Loesenbeck - Specht - Dantz**
**Patent- und Rechtsanwälte**
**Am Zwinger 2**
**33602 Bielefeld (DE)**

(56) Entgegenhaltungen:
**EP-A1- 3 336 909      US-A- 5 966 939**
**US-A1- 2001 013 224**

**Beschreibung**

Die Erfindung betrifft eine Vorrichtung zur Kälte- und Stromerzeugung gemäß Anspruch 1.

Peltier-Elemente sind hinlänglich bekannt. Beispielhaft wird auf die Veröffentlichungen verwiesen, in denen das Prinzip der Peltier- und Seebeck-Physik sowie deren Anwendungen beschrieben wird.

Bei geringem Kältebedarf finden herkömmliche Peltier-Elemente Anwendung. Dabei sind in der Regel die N-P bzw. P-N dotierten Halbleiter als separate Bauteile elektrisch in Reihe und thermisch parallel angeordnet. Die Wärmezufuhr und -abfuhr erfolgt beidseitig durch wärmeübertragende Platten (z.B. keramisches Trägermaterial). Die Systeme werden mittels einer Gleichstromquelle betrieben, wobei je nach Stromrichtung eine Temperaturerhöhung bzw. Temperaturabnahme an den Kontaktstellen der unterschiedlichen Halbleiter stattfindet.

Die unterschiedlichen Halbleiter der Thermopaare $T_1$ bzw. $T_2$ sind bei den herkömmlichen Peltier-Elementen auf engstem Raum mit der Folge angeordnet, dass die räumliche Nähe der wärmeabgebenden und wärmeaufnehmenden Flächen zu einem unerwünschten Wärmestrom über die Halbleiterelemente zu erheblichen Verlusten hinsichtlich der erzeugten Kälte- oder Wärmeleistung führt.

Neben der Wärmeleitung durch den Elektronenstrom und phononische Wärmeleitung erfolgt zusätzlich eine weitere unerwünschte Wärmeübertragung durch Wärmestrahlung und Konvektion in einem in der Regel durch Versiegelung abgeschlossenem System.

Der Transport der Wärmeenergie wird von fließenden Elektronen übernommen, d.h. die zu transportierende Wärmeenergie pro Zeiteinheit $Q_0$ verhält sich annähernd proportional zur Stromstärke I ($Q_0 \sim I$).

Durch Änderung der Stromrichtung kann die thermische Wirkung vertauscht werden. Bei Beheizung und Kühlung der wärmeübertragenden Flächen können Peltier-Elemente bei Wegfall der Gleichstromquelle auch als Generator fungieren.

Herkömmliche Peltier-Elemente (CN 103 000 799 A, JP 2005-228915) können bei Wegfall der Gleichstromquelle und stattdessen durch Beheizung und Kühlung der wärmeübertragenden Flächen auch als Generator fungieren.

Die Stromstärke I und damit auch die Kälteleistung $Q_0$ ist andererseits jedoch in Hinblick auf die entstehenden Joule'schen Wärmeverluste $Q_{Joule}$ begrenzt, da diese mit der 2. Potenz ($Q_{Joule} = I^2 \times R$) in die Gesamtrechnung eingeht und damit der thermoelektrische Wirkungsgrad (COP-Wert) mit steigender Stromstärke I sich nicht nur verschlechtert, sondern das die Joule'schen Wärmeverluste $Q_{Joule}$ in der Gesamtrechnung bilanziert, überwiegen können, d. h. dass die erzeugte Kälteleistung $Q_0$ sich nicht nur vermindert sondern gänzlich aufgezehrt wird.

Dies ist neben konstruktiven Gründen ein wichtiger Anlass, für die bei herkömmlichen Peltier-Elementen allgemein praktizierte komplette elektrische Reihenschaltung der Thermopaare (Kontaktstellen) $T_1$ und $T_2$. Dabei wird ein maximal optimierter Stromfluss durch mehrfach in Reihe angeordnete Thermopaare $T_1$ und $T_2$ geleitet und verursacht (je nach Definition) jeweils einen Wärmeentzug bzw. Wärmeabgabe im Bereich der Thermopaare $T_1$ und $T_2$.

Die Verluste durch Wärmeleitung $Q_L$ und Joule'sche Wärme $Q_{Joule}$ sind der Hauptgrund für den niedrigen thermoelektrischen Wirkungsgrad (COP-Wert) herkömmlicher Peltier-Elemente, so dass eine Verwendung dieser Peltier-Elemente für größere Leistungsbereiche bislang keinen Sinn ergibt.

In der US 2001/013224 A1 ist ein mehrschichtiger Wärmetauscher für strömende Medien offenbart, bei dem pro Schicht thermoelektrisch nach dem Peltier-Prinzip eine Temperaturdifferenz zwischen strömenden Medien hergestellt wird.

Dabei weisen mehrere TE-Einzelwärmetauscher jeweils N-P-dotierte Thermopaare auf, die elektrisch in Reihe geschaltet sind.

Ein vergleichbarer Wärmetauscher ist in der US 5 966 939 A gezeigt und beschrieben, dessen TE-Einzelwärmetauscher ebenfalls elektrisch in Reihe geschaltete Thermopaare aufweisen.

Schließlich ist in der EP 3 336 909 A1 eine Konstruktion thematisiert, die mehrstufige Peltier-Elemente aufweist, mit P- und N-dotierten Halbleitern, die über Stromleiter einzeln in Reihe geschaltet sind.

Der Erfindung liegt die Aufgabe zugrunde, eine gattungsgemäße Vorrichtung so weiterzuentwickeln, dass ihr Anwendungsbereich erweitert wird, insbesondere um größere Kälteleistungen und gleichzeitig erheblich verbesserten thermoelektrischem Wirkungsgrad zu erreichen.

Diese Aufgabe wird durch eine Vorrichtung mit den Merkmalen des Anspruchs 1 gelöst.

Danach sind ein wärmeaufnehmendes Teil in einem Innenteil und ein wärmeabgebendes Teil in einem Außenteil räumlich und thermisch voneinander getrennt auf einem gemeinsamen Grundrahmen angeordnet, wobei die schädliche Wärmeleitung $Q_L$ und die Joule'schen Wärmeverluste $Q_{Joule}$ vermindert werden.

Die Vorrichtung besteht im Wesentlichen aus den thermoelektrischen TE-Einzelwärmeaustauschern, die jeweils mit in großer Zahl N-P dotierten Thermopaare versehen sind. Metallische Leiterplatten bestehen aus elektrisch und thermisch gut leitendem Material (z.B. Kupfer). Sie dienen zur elektrischen Stromführung und gleichzeitig zu einer optimalen Wärmeübertragung an die in gebildeten Luftspalten vorbeiströmende Luft. Jegliche weiteren Wärmewiderstände wie z.B. wärmeleitende Isolierfolie, Glimmer oder Al2O3 Keramik, wie sie bei herkömmlichen Peltier-Elementen verwendet werden, entfallen.

Im Weiteren durch eine speziell kombinierte elektrische Parallel- und Reihenschaltung der N-P bzw. P-N dotierten Halbleiter, ferner durch die in der Beschreibung aufgeführten Anordnungs- und Ausführungsmöglichkeiten der N-P bzw. P-N dotierten Halbleiterelemente sowie durch parallel geschaltete metallische Verbindungsleiter, geeigneter Werkstoffauswahl der metallischen Leiter, optimale Verbindung zwischen Innenteil und Außenteil inklusive einer allgemein bisher noch nicht angewandten Kühlung der metallischen Verbindungsleiter durch Außenluft erreicht.

Die TE-Einzelwärmeaustauscher besitzen im Bereich der N-P bzw. P-N dotierten Halbleiter sowie an den äußeren Oberflächen der Leiterplatten im Beharrungszustand eine annähernd gleiche Temperatur. Die Wärmeübertragung erfolgt ausschließlich über die äußere Oberfläche der metallischen Leiterplatten. Es sind keine Wärmespannungen vorhanden. Der Innenraum dient nur zur Aufnahme der in großer Zahl angeordneten gleichartigen N-P bzw. P-N dotierten Halbleiter.

Die deutliche Erhöhung des thermoelektrischen Wirkungsgrads (COP-Wert) bei einer derartig ausgebildeten thermoelektrischen Vorrichtung begründet sich also im Wesentlichen in der Verminderung der Joule'schen Wärmeverluste sowie der Verminderung der schädlichen Wärmeleitung.

Damit entspricht die erfindungsgemäße thermoelektrische Vorrichtung auf der Basis der Peltier-Seebeck-Physik insbesondere auch den leistungsmäßigen und wirtschaftlichen Anforderungen der Kälte-, Klima-, Labor- und Verfahrenstechnik. Dies war bislang in wirtschaftlich und technisch akzeptabler Weise nicht möglich.

Die Vorrichtung soll trotzdem herkömmliche Peltier- Elemente mit kleiner Leistung nicht verdrängen, sondern den Anwendungsbereich der Peltier- und Seebeck-Physik für größerer Kälteleistungen bei gleichzeitig erheblich verbessertem thermoelektrischen Wirkungsgrad (COP-Wert) erweitern.

Der erzielbare höhere thermoelektrische Wirkungsgrad (COP-Wert) ist vergleichbar mit dem COP-Wert eines Kompressionskältekreislaufes unter ähnlichen Bedingungen, beispielsweise:

| Rechenbeispiel gem. Anwendungsbeispiel 2 | | | | | | | | | |
|---|---|---|---|---|---|---|---|---|---|
| | | | | | | | | | |
| $T_w$ | $T_o$ | $\Delta T$ | $\alpha$ Thermokraft | I total | $I_{TP}$ Thermopaar | $T_U$ | Anzahl der WT (6) | Anzahl der TP pro WT (6) | Gesamtzahl der Thermopaare |
| 313 | 263 | 50 | 4,00E-04 | 36 | 1,00 | 303 | 45 | 36 | 1620 |
| [K] | [K] | [K] | [mV/K] | [A] | [A] | [K] | [-] | [-] | [-] |
| | | | | | | | | | |
| Peltier-Effekt | | | $Q_P$ | 1,70E+02 | [W] | | | | |
| | | | | | | | | | |
| Joule'sche Wärme | | | $Q_J$ | 11,34 | [W] | | | | |
| | | | | | | | | | |
| Wärmeleitung | | | $Q_L$ | 12,11 | [W] | | | | |
| | | | | | | | | | |
| Kälteleistung | | | $Q_O$ | 1,50E+02 | [W] | | | | |
| I | | | | | | | | | |
| Abzuführende Wärmeenergie | | | $Q_W$ | 2,03E+02 | [W] | | | | |
| | | | | | - | | | | |
| Indizierte elektrische Leistung | | | $Q_I$ | 4,37E+01 | [W] | | | | |
| | | | | | | | | | |
| Kälteleistungszahl | | | COP | 3,42E+00 | [-] | | | | |
| | | | | | | | | | |
| Spannung | | | U | 1,22E+00 | [V] | | | | |
| | | | | | | | | | |
| | Formeln und Zeichen : | | | | | | | | |
| | | | | | | | | | |
| | Peltier-Effekt = $Q_{Peltier=}$ | | $T_k \times \alpha_{Thermokrat} \times I$ | | | | | [W] | |
| | | | | | | | | | |

(fortgesetzt)

| Rechenbeispiel gem. Anwendungsbeispiel 2 | | | | | |
|---|---|---|---|---|---|
| Joule'sche Wärme $Q_{Jo}$ | $\frac{1}{2} \times I^2 \times R_{total}$ | | | [W] | |
| | | | | | |
| Kälteleistung $Q_0 = T_k \times \alpha_{Thermokraft} \times I - \frac{1}{2} \times I^2 \times R_{total} - W_L$ | | | | [W] | |
| | | | | | |
| Abzuführende Wärmeenergie $Q_W =$ | $T_w \times \alpha_{Thermokraft} \times I + \frac{1}{2} \times I^2 \times R_{total} - \lambda^* \Delta T$ | | | [W] | |
| | | | | | |
| Indizierte elektrische Leistung $Q_I =$ | $\alpha_{Thermokraft} {}^* \Delta T {}^* I + I^2 {}^* R_{total}$ | | | [W] | |
| | | | | | |
| Kälteleistungszahl (COP-Wert) = | $Q_0/Q_I$ | | | [-] | |
| | | | | | |
| Wärmeleitung pro Leite | = | $A {}^* \lambda {}^* \Delta T / L$ | | [W] | |
| | | | | | |
| Wärmeleitung $Q_{L\,gesamt}$ | $Q_L {}^*$ Anzahl der Leiter | | | [W] | |
| | | | | | |
| Ohmscher Widerstand | $\rho_{20}{}^* L/A$ | | | $[\Omega]$ | |
| | | | | | |
| Ohmscher Widerstand | $R_{20}{}^*(1+\alpha_{20}{}^*(t-20°C))$ | | | $[\Omega]$ | |
| | | | | | |
| Spannung $U = I {}^* R$ | | | | [V] | |
| | | | | | |
| Leistung $N = U {}^* I$ bzw. $I^2 {}^* R$ | | | | [W] | |
| | | | | | |
| | | | | | |
| $T_K$ | Peltier-Temperatur Kaltseite | | | [K] | |
| $\alpha$ | Thermokraft | | | [Volt/Kelvin] | |

(fortgesetzt)

| Rechenbeispiel gem. Anwendungsbeispiel 2 | | | | | | | | |
|---|---|---|---|---|---|---|---|---|
| | I | Strom Ampere | | | | | [A] | |
| | A | Querschnittsfläche | | | | | $[m^2$ bzw. $mm^2]$ | |
| | A | Wärmeleitfähigkeit | | | | | [W/mK] | |
| | $\Delta T$ | Temperaturdifferenz warme/kalte Seite $T_W$ -$T_K$ | | | | | [K] | |
| | L | Länge | | | | | [m] | |
| | $T_W$ | Peltier-Temperatur Warmseite | | | | | [K] | |
| | R | Ohmscher Widerstand | | | | | $[\Omega]$ | |
| | $R_{20}$ | Ohmscher Widerstand bei 20°C | | | | | $[\Omega]$ | |
| | 020 | Temperaturkoeffizient bei 20°C | | | | | [1/°C] | |
| | $\rho_{20}$ | Spezifischer Widerstand bei 20°C | | | | | $[\Omega * mm^2/m]$ | |
| | $R_t$ | Ohmscher Widerstand bei Temperatur t | | | | | $[\Omega]$ | |
| | U | Spannung | | | | | [V] | |
| | N | Leistung | | | | | [W] | |
| | $R_{par}$ | Parallelwiderstand | | | | | $[\Omega]$ | |
| | $R_n$ | Einzelwiderstand von n gleichen Widerständen | | | | | $[\Omega]$ | |
| | n | Anzahlder gleichen Widerstände | | | | | [-] | |
| | $T_U$ | Umgebungstemperatur | | | | | [K] | |
| | WT | Wärmeaustauscher | | | | | [-] | |
| | TP | Thermopaar | | | | | | |
| | | | | | | | | |

Im Gegensatz hierzu erfolgt der Transport der Wärmeenergie ausschließlich über den Elektronenfluss, d.h. die Kälteleistung verhält sich proportional zur elektrischen Stromstärke.

Im weiteren Vergleich zu einem Kompressionskältekreislauf entfallen Kältekompressor, kältetechnisches Zubehör, Kältemittel und Kältemaschinenöl. Verdampfer- und Kondensator werden jedoch jeweils durch eine Vielzahl thermoelektrischer TE-Einzelwärmeaustauscher, die im Innenteil und Außenteil jeweils zu einem Gesamtwärmeaustauscher zusammengefasst sind ersetzt.

Der benötigte Gleichstrom kann bauseits durch ein Energiespeichersystem in der benötigten Gleichstromspannung und Leistung bereitgestellt werden.

Durch den Wegfall eines geschlossenen Gaskreislaufes mit wechselndem Aggregatzustand entfallen Undichtigkeiten und damit einhergehende Umweltverschmutzung durch Kältemittel und Öl.

Die kälteseitigen Einsatzmöglichkeiten können ein- bzw. mehrstufig erfolgen.

Im Beharrungszustand stellt sich -ähnlich wie bei herkömmlichen Peltier-Elementen gemäß Auslegung und Einflussparameter eine Temperaturdifferenz zwischen der wärmeaufnehmenden und wärmeabgebenden Seite ein.

Ein gewünschtes Teillastverhalten kann z.B. durch Regelung des Elektronenstromes hergestellt werden.

Abgesehen von der Ventilation arbeitet das PW-System geräuschlos und besitzt keine weiteren bewegten Bauteile.

Zur Vermeidung von Verschmutzung und Korrosion ist deshalb der Innenraum im Ganzen mit elektrisch nicht leitendem Material (z.B. 2K-Elektro-Vergussmasse) komplett ausgefüllt oder auch nur im Randbereich durch Kunststoff versiegelt.

Weitere vorteilhafte Ausbildungen der Erfindung sind in den Unteransprüchen gekennzeichnet.

Ausführungsbeispiele der Erfindung werden nachfolgend anhand der beigefügten Zeichnungen beschrieben.

Es zeigen:

Figur 1          eine erfindungsgemäße Vorrichtung in einer teilweise geschnittenen schematischen perspektivischen Ansicht

Figur 2          einen Teilausschnitt der Vorrichtung, gleichfalls perspektivisch abgebildet

Figur 3          eine schematische Draufsicht auf ein Peltier-Element nach der Erfindung

Figur 4          einen Teil des Peltier-Elementes in einer teilweise geschnittenen, perspektivischen Ansicht

Figur 5 A) - 5 G)   verschiedene Ausführungsvarianten von Halbleiterelementen nach der Erfindung, jeweils in einer Draufsicht.

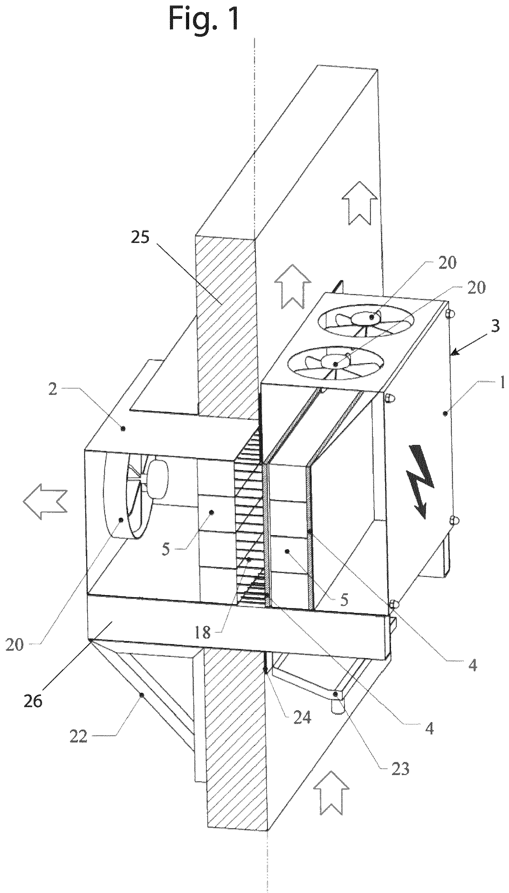

In der Fig.1 ist die in eine Außenwand 25 eingebaute Vorrichtung prinzipiell dargestellt. Sie besteht aus einem Innenteil 1 und einem Außenteil 2 die räumlich und thermisch durch eine wärmeisolierende Platte 4 getrennt auf einen gemeinsamen Grundrahmen 26 montiert sind.

Ein im Innenteil 1 angeordneter TE-Gesamtwärmeaustauscher 5 ist ohne Zwischenraum zwischen zwei wärmeisolierenden Platten 4 platziert. Die Luftführung innen erfolgt mittels Ventilation 20 von unten über eine Tropfwassersammelschale 23 durch das an dieser Stelle offene Gehäuse senkrecht gemäß Richtungspfeilen über den TE-Gesamtwärmeaustauscher 5 nach oben.

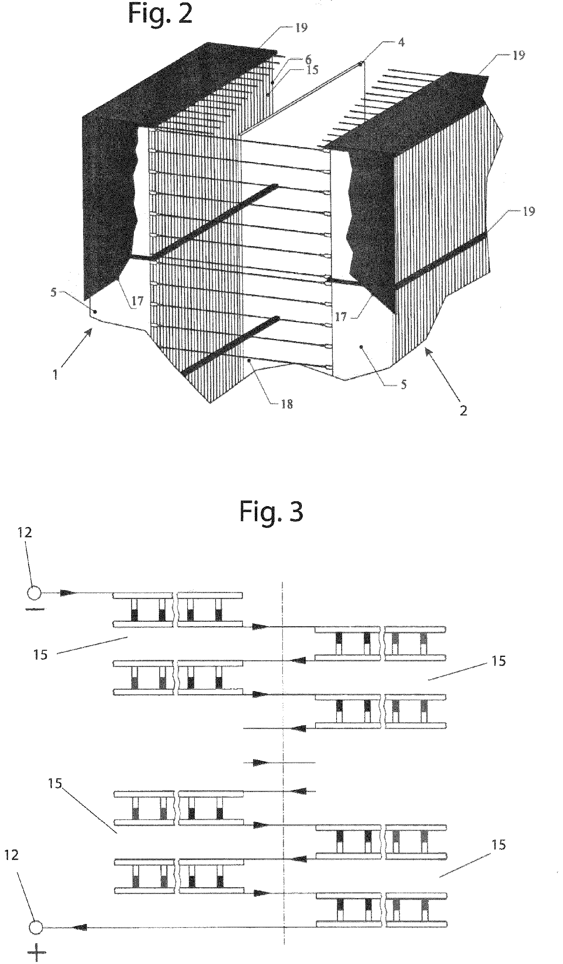

Ein im Außenteil 2 spiegelbildlich angeordneter TE-Einzelwärmeaustauscher 6 (Figur 2) ist durch eine größere Zahl von metallischen Leitern 18 einzeln mit einem im Innenteil 1 angeordneten TE-Einzelwärmeaustauscher 6 elektrisch verbunden. Dabei durchdringt jeder einzelne metallische Leiter 18 abgedichtet die wärmeisolierende, elektrisch nichtleitende Platte 4.

Ein Mauerdurchbruch ist für die über die metallischen Leiter 18 konzentrisch geführte Außenluft in Breite und Höhe grösser ausgeführt.

Gehäusemäßig und in der weiteren Ausstattung wie z.B. Filter, Art der Ventilation, ggf. alternative Luftführung, Regelung, Ausführung der Tropfwasserwanne sowie weiteres Zubehör und auch Festlegung individueller Abmessungen können je nach Bedarf erfolgen.

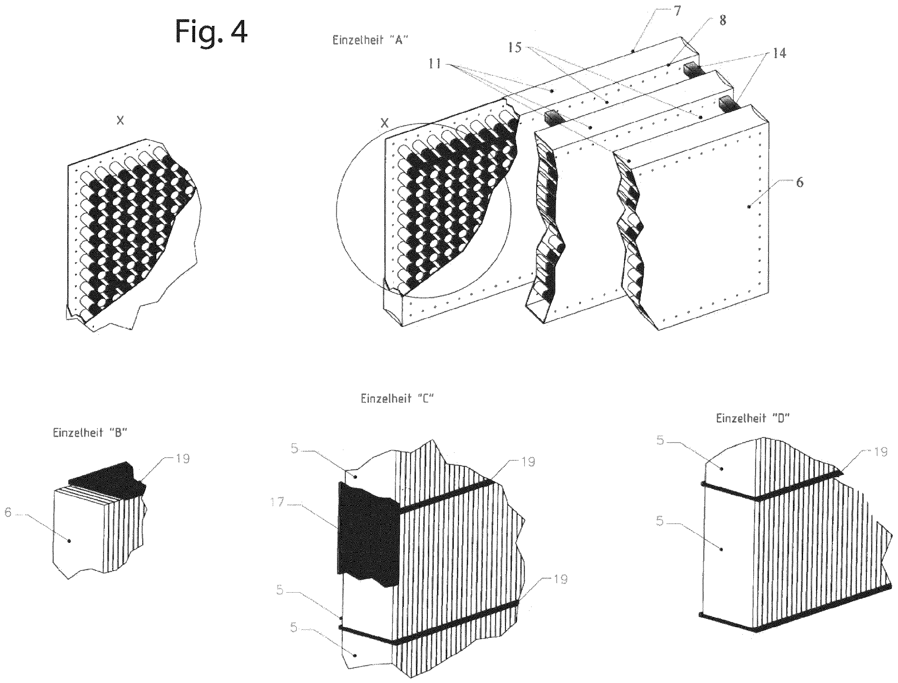

Gemäß Fig. 4 Einzelheit "A" bestehen die TE-Einzelwärmeaustauscher 6 jeweils aus zwei parallelen metallischen Leiterplatten 7, zwischen denen in physikalischer Stromrichtung gesehen in großer Zahl N-P dotierte Thermopaare 9, 10 angeordnet sind. Die metallischen Leiterplatten 7, 8 bestehen aus elektrisch und thermisch gut leitendem Material (z.B. Kupfer). Sie dienen gleichzeitig zur elektrische Stromführung sowie zur Wärmeübertragung der erzeugten Kälte/Wärmeenergie an die in den Luftspalten 15 vorbeiströmende Luft.

Zur Vermeidung von Verschmutzung und Korrosion ist der in großer Zahl mit Thermopaaren 9, 10 bestückte Innenraum zwischen den metallischen Leiterplatten 7, 8 ringförmig nach außen mit elektrisch nicht leitendem Material 11 (z.B. Kunststoff) versiegelt.

Im Innenteil 1 und Außenteil 2 sind die in großer Zahl benötigte TE-Einzelwärmeaustauscher 6 zu jeweils einem TE-Gesamtwärmeaustauscher 5 gebündelt und wahlweise nebeneinander, untereinander u. ggf. auch hintereinander angeordnet. Für diese modulare Anordnung sind sie elektrisch und mechanisch mit entsprechenden Anschlüssen 12 und mit elektrisch isolierende Abstandshaltern 14 versehen.

Da es sich bei den beschriebenen Thermopaaren 9, 10 um in physikalischer Stromrichtung gleichartige Thermopaare von z.B. alle N-P bzw. alle P-N dotiert handelt, können diese die erzeugte Kälte/Wärmeenergie direkt auf die metallischen Leiterplatten 7, 8 beidseitig übertragen. Neben der Weiterleitung der Wärmeenergie übernehmen sie auch gleichzeitig die Funktion Stromführung und müssen deshalb im Gesamtwärmeaustauscher 5 aber auch gegenüber dem Gehäuse 3 elektrisch isoliert ausgeführt werden (siehe hierzu gem. Figur 4 Einzelheit "A", "B", "C" und "D").

Die bei herkömmlichen Peltier-Elementen eingesetzten wärmeleitungshemmenden Folien- oder elektrisch nichtleitenden Keramikabdeckungen entfallen. Stattdessen sind Innenteil 1 und Außenteil 2 räumlich und thermisch getrennt.

Gemäß Figur 2 sind die stirnseitigen Berührungsflächen der modular angeordneten TE-Einzelwärmeaustauscher 6 sowie die komplette Abgrenzung 16 des TE-Gesamtwärmeaustauscher 5 gegenüber dem Gehäuse 3 mit elektrisch und wärmeisolierendem druckfestem Material 19 versehen.

Der gemäß Fig. 1 im Außenteil 2 spiegelbildlich eingebaute TE-Gesamtwärmeaustauscher 5 entspricht konstruktiv der Ausführung im Innenteil 1. Aufgrund der spiegelbildlichen Anordnung des Wärmeaustauscher-Gesamtsystems werden die Thermopaare 9, 10) vom elektrischen Strom in umgekehrter Richtung, also von P-dotiert nach N- dotiert beaufschlagt. Dabei gelangen die Elektronen vom P- dotierten energetisch höherem Leitungsband in das N- dotierte energetisch niedrigere Leitungsband und geben die Energiedifferenz als Wärme an die Umgebung ab.

In der Regel findet eine luftgekühlte Ausführung Anwendung. Dabei werden die belüfteten freiliegenden metallischen Verbindungsleiter 18 zwischen Innenteil 1 und Außenteil 2 durch die hierüber geführte Außenluft auf ein Temperaturniveau von ca. 5 K > Außentemperatur gekühlt. Dies bedeutet, dass auch bei widrigen Betriebszuständen, d.h. z.B. im Anfahrzustand oder bei leistungsmäßiger Überlastung der Vorrichtung eine u. U. höhere schädliche Wärmeleitung begrenzt bleibt.

Anschließend wird die Außenluft über den TE-Gesamtwärmeaustauscher 5 weitergeführt und durch diesen auf ein Temperaturniveau je nach Auslegung und Luftmenge auf ein Temperaturniveau von ca. 10-12 K > Umgebungstemperatur gekühlt.

Anordnungs- und Ausführungsmöglichkeiten der N-P dotierten Halbleiterelemente:

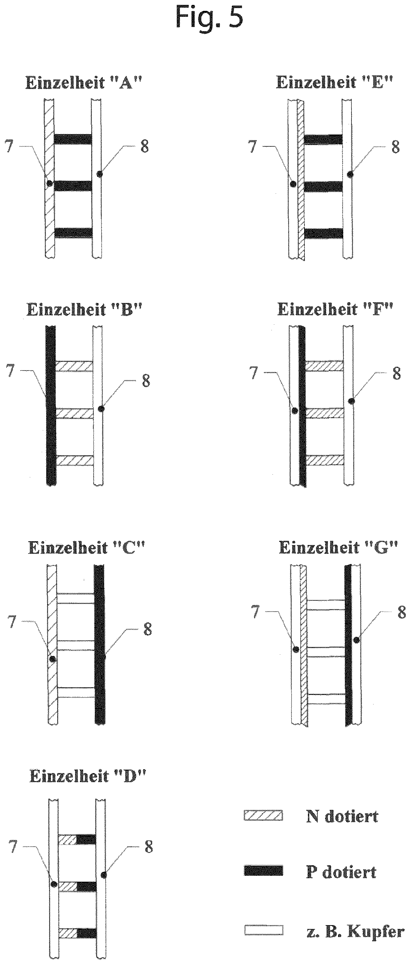

Gem. Figur 5 ergeben sich eine Reihe von Anordnungs- und Ausführungsmöglichkeiten der N-P dotierten Halbleiterelemente:

Einzelheit "A":
Hier besteht die ursprünglich metallische Leiterplatte 7 komplett aus N dotierten und die Verbindung zwischen den metallischen Leiterplatten aus P dotierten Halbleitermaterial, die metallische Leiterplatte 8 aus z.B. Kupfer.

Einzelheit "B":
Hier besteht die Leiterplatte 7 komplett aus P dotierten und die Verbindung zwischen den Leiterplatten aus N dotierten Halbleitermaterial, die Leiterplatte 8 aus z.B. Kupfer.

Einzelheit "C":
Hier besteht die Leiterplatte 7 komplett aus N dotierten und die Verbindung zwischen den Leiterplatten z.B. aus Kupfer, die Leiterplatte 8 komplett aus P-dotierten Halbleitermaterial.

Einzelheit "D":
Hier bestehen die metallische Leiterplatte 7 und 8 komplett aus z.B. Kupfer und die Verbindung zwischen den metallischen Leiterplatten 7 und 8 aus einem N-P dotierten Thermopaar.

Einzelheit "E, F und G":
Anstelle dass die Leiterplatten gem. Einzelheit "A", "B", und "C" jeweils teilweise oder ganz aus dotiertem Halbleitermaterial bestehen, können aus kosten-, herstellungs- bzw. konstruktiven Gründen die nach innen gewandten Flächen mit Halbleitermaterial beschichtet und als die nach außen zugewandten Leiterplatten 7 und 8 ganz oder teilweise z.B. aus Kupfer in Sandwich-Ausführung hergestellt werden.

Die zu wählende Schichtdicken müssen dabei ausreichend bemessen sein, um gem. Bändertheorie für Festkörper den thermophysikalischen Prozess des beteiligten Elektronenstromes vom niedrigeren in den höheren Energiezustand und umgekehrt zu gewährleisten.

Elektrische Schaltungen:

Wie in Fig. 3 dargestellt, sind die TE-Einzelwärmeaustauscher 6 des Innenteils 1 und des Außenteils 2 jeweils über mehrere parallel geschaltete metallische Leiter 18 elektrisch verbunden und in Reihe geschaltet.

Der einzuspeisende Gesamtstrom I wird dem Innenteil 1 zugeführt und hier im ersten TE-Einzelwärmeaustauscher 6 über die metallischen Leiterplatte auf eine große Zahl parallel angeordneter Thermopaare 9, 10 verteilt. Über die metallische Leiterplatte 8 erfolgt die elektrische Weiterleitung mittels ebenfalls mehreren parallel geschalteter metallischer Leiter 18 an die gegenüberliegende metallische Leiterplatte 8 des im Außenteil 2 befindlichen TE-Einzelwärmeaustauschers 6.

Die Thermopaare 9, 10 sind im TE-Wärmeaustauscher 6 des Innenteiles 1 in physikalischer Stromrichtung gesehen N-P dotiert, im TE-Wärmeaustauscher 6 des Außenteiles 2 spiegelbildlich, also P-N dotiert angeordnet.

Gemäß Bändertheorie für Festkörper gelangen die Elektronen somit vom N-dotierten energetisch niedrigerem Energiezustand in den energetisch höheren Energiezustand der P- dotierten Halbleiter und nehmen die Energiedifferenz als Wärme aus der Umgebung auf.

Im Außenteil 2 ist es dann umgekehrt. Hier gelangen die Elektronen in physikalischer Stromrichtung gesehen vom P- dotierten in den N-dotierten Zustand und geben die Energiedifferenz als Wärme an die Umgebung ab.

Für normale metallische Leiter, die gemäß thermoelektrischer Spannungsreihe nur eine geringe thermoelektrische Wirkung aufweisen, aber für Labor- und Messzwecke einen hervorragenden Platz einnehmen, wird im Rahmen dieser Erfindung ebenfalls Patentschutz beansprucht.

Die hier beschriebenen elektrisch verbundenen TE-Einzelwärmetauscher 6 sind nun in Folge elektrisch in Reihe geschaltet und bilden im Innenteil 1 und Außenteil 2 jeweils den TE-Gesamtwärmeaustauscher 5.

Durch die parallele Anordnung der N-P bzw. P-N dotierten Halbleiterelemente in den TE-Einzelwärmeaustauschern 6 ergibt sich eine wesentliche Verringerung des Ohmschen Widerstandes nach der Beziehung:

$$R_{parallel} = R_n \,/\, \text{Anzahl}_{\text{der Stränge } n^*} \; .$$

*) Bei gleichen Widerständen ist der Gesamtwiderstand so groß wie der durch die Anzahl der Widerstände dividierte Einzelwiderstand. Bei Gleichstrombetrieb ist er stets geringer als der kleinste Einzelwiderstand.

Damit wird auch der Widerstand der TE-Gesamtwärmeaustauscher 5 auf ein Minimum reduziert.

Gleichzeitig verringert sich durch die Aufteilung der Gesamtstrommenge im Bereich der TE-Einzelwärmeaustauscher 6 in Stromgrößen < 1 die Joulesche Wärme auf

$$Q_{\text{Joule}} = I_n^2 \; x \; R_n \; x \; \text{Anzahl}_{\text{der Stränge } n}$$

oder

$$Q_{\text{Joule}} = I_{ges}^2 \; x \; R_{parallel} \quad .$$

Um die Jouleschen Verluste noch weiter zu verringern ist die elektrische Verbindung zwischen den einzelnen TE-Wärmeaustauschern 6 des Innenteils 1 und Außenteils 2 ebenfalls in eine größere Zahl parallel geschaltete Leiter 18 aufgeteilt.

Durch diese parallele Aufteilung verringern sich nicht nur weiter die Joule'schen Wärmeverluste sondern es verbessert sich infolge der vergrö-βerten Oberfläche der metallischen Leiter 18 auch der Wärmeübergang zwischen der Umgebungsluft und den metallischen Leitern 18 und verstärkt damit deren Abkühlwirkung.

Die wärmeaufnehmenden und wärmeabgebenden Platten eines Peltier-Elements räumlich zu trennen und dessen gleichartig dotierte Halbleiter zu verdoppeln und dabei die einzelnen N-P bzw. P-N dotierten Thermopaare mittels metallischer Leiter elektrisch einzeln in Reihe zu schalten, ist bekannt (CN 103 000799 A).

Im Gegensatz hierzu sind anstelle von nur einem oder wenigen Thermopaaren pro Stufe in den TE-Einzelwärmeaustauschern 6 die Thermopaare in großer Zahl parallel in jeder einzelnen Stufe angeordnet. Die daraus zu bewältigende Stromstärke (pro Thermopaar ≈ 1 A) ist ungleich höher und erfordert damit eine Aufteilung auf mehrere parallel geschaltete metallische Leiter 18.

Herstellung:

Allein ein herkömmliches Peltier-Element mit einer Kühlleistung von ca. 30 W verfügt über mehr als 400 Einzelteile. Die Anforderungen an maßliche Genauigkeit und mechanischen Fertigung/ Zusammenbau sowie die bei Betrieb unterschiedlichen thermischen Beanspruchungen sind überaus hoch.

Die bei größeren Kälteleistungen benötigte viel größere Anzahl von Thermopaaren (9,10) macht ein Umdenken bei der Herstellung von erfindungsgemäßen Peltier-Elementen gegenüber der Fertigung herkömmlicher Peltier-Elemente erforderlich.

Es bietet sich für die Herstellung ein spezielles 3-D-Druckverfahren an.

Anstelle der Anordnung zwischen elektrisch isolierenden Folien/KeramikAbdeckungen bei herkömmlichen Peltier-Elementen werden die Thermopaare 9,10 direkt auf die Flächen der metallischen Leiterplatten 7, 8 einheitlich und punktgenau verbracht.

Auch hier muss die Oberfläche der Innenseite der metallischen Leiterplatten 7, 8 für den schichtweisen Aufdruck des N- oder P- dotierten Halbleitermaterials vorbereitet sein.

Eine feste metallische Verbindung zwischen metallischen Leiterplatten 7, 8 und den unterschiedlich dotierten Halbleitern kann je nach Betriebstemperatur durch geeignetes Lötmaterial hergestellt werden.

Beim Betrieb der Vorrichtung stellen sich in den TE-Einzelwärmeaustauscher 6 im Innenteil 1 oder Außenteil 2 unterschiedliche Betriebstemperaturen ein. Über die kompletten jeweiligen TE-Einzelwärmeaustauscher 6 ist die Temperatur jedoch annähernd gleichmäßig verteilt, so dass im Gegensatz zu herkömmlichen Peltier-Elementen z.B. bei unterschiedlichen Materialausdehnungskoeffizienten keine schädlichen Spannungskräfte entstehen.

Hinzu kommt, dass die Kälte- oder Wärmeübertragung bereits im Innenteil 1 oder Außenteil 2 über den jeweiligen Luftstrom an die Umgebung erfolgt und nicht durch zusammengefügte, sich berührende unterschiedliche Materialien bewirkt wird wodurch Spannungskräfte entstehen.

Da der über die parallel geschalteten einzelnen Thermopaare 9,10 reduzierte Stromfluss von < 1 A auch geringere Abmessungen der Halbleiterpaare ermöglicht, können diese in wesentlich größerer Zahl gegenüber herkömmlichen Peltier-Elementen- und besonders wirtschaftlich durch ein spezielles 3D-Druckverfahren in Teilen oder in Gänze auf die metallischen Leiterplatten aufgebracht werden.

Bei größeren Leistungen werden die TE-Einzelwärmeaustauscher 6 in Modulbauweise elektrisch und mechanisch zusammengefasst.

Ein 3D-Druckverfahren hat den Charme, dass PW-Systeme auch bei geringeren Stückzahlen oder auch in spezieller Konfiguration in kurzer Zeit hergestellt, ausprobiert und geliefert werden können.

Wie bei herkömmlich konzipierten Peltier-Elementen kann auch bei einem neuen Peltier-Element durch Änderung der Stromrichtung die thermische Wirkung vertauscht werden.

Die Vorrichtung kann generell als Generator nach der Grundformel:

$$U_{Thermo\ ohne\ Last} = \alpha_{\ Thermokraft} \times \Delta T \times Anzahl_{\ der\ Stufen}$$

fungieren.

Auch hier ist die Kombination von Parallel- und Reihenschaltung der Thermopaare 9,10 und metallischen Leitern 18 bei gleichzeitig räumlich getrenntem Innenteil 1 und Außenteil 2 die Voraussetzung um eine nennenswerte Leistung bei hohem thermoelektrischem Wirkungsgrad ( $\eta$ ) zu generieren.

Wie unter "Elektrische Schaltungen" *bereits* ausführlich beschrieben, reduzieren sich durch diese Kombination erheblich der elektrische Gesamtwiderstand $R_{gesamt}$ und gleichzeitig bei paralleler Aufteilung der Stromstärke die bei Betrieb massiv auftretenden Jouleschen Wärmeverluste. Nur so lässt sich die notwendige große Stufenanzahl bei gleichzeitig hoher Stromstärke für eine nennenswerte Verbraucherleistung verwirklichen.

Für einen dauerhaft optimierten Generatorbetrieb müssen der externe verbraucherseitige Ohmsche Widerstand rechnerisch berücksichtigt und die notwendige Wärmezufuhr/Abfuhr und sichergestellt werden. Auch bei nicht allzu großem Temperaturunterschied wie etwa bei "Abfallwärme" lohnt sich bereits diese Art von Stromerzeugung.

**Bezugszeichenliste**

(1)  Innenteil
(2)  Außenteil
(3)  Gehäuse
(4)  Elektrisch und wärmeisolierende Trennwand

(5)     TE- (thermoelektrischer) Gesamtwärmeaustauscher
(6)     TE-Einzelwärmeaustauscher
(7)     Metallische Leiterplatte
(8)     Metallische Leiterplatte
(9)     N-dotierter Halbleiter
(10)    P-dotierter Halbleiter
(11)    Versiegelung
(12)    elektrische Anschlüsse

(14)    Elektrisch isolierende Abstandshalter
(15)    Luftspalt
(16)    Abgrenzung

(18)    Metallische Verbindungsleiter
(19)    Elektrisch/wärmeisolierendes druckfestes Material
(20)    Ventilation

(22)    Konsole
(23)    Tropfwassersammelschale
(24)    Abdichtrahmen
(25)    Außenwand
(26)    Grundrahmen

**Patentansprüche**

1.  Vorrichtung zur Kälte- und Stromerzeugung nach dem Prinzip von Peltier, die einen wärmeaufnehmenden und einen wärmeabgebenden Teil aufweist, wobei unter Ausbildung von thermoelektrischen TE- Einzelwärmetauschern (6), die zu mindestens zwei TE-Gesamtwärmetauschern (5) zusammengefasst sind, jeweils ein wärmeaufnehmender und ein wärmeabgebender TE-Gesamtwärmetauscher (5), die räumlich voneinander getrennt sind, wobei der wärmeaufnehmende TE-Gesamtwärmetauscher (5) in einem Innenteil (1) der Vorrichtung und der wärmeabgebende TE-Gesamtwärmetauscher (5) in einem Außenteil (2) der Vorrichtung angeordnet sind, und jeder TE- Einzelwärmetauscher (6) parallel und abständig zueinander positionierte Leiterplatten (7,8) aufweist, mit in Stromrichtung gesehen N-P oder P-N dotierten Thermopaaren, die elektrisch parallel geschaltet sind, wobei jeder TE-Einzelwärmetauscher (6) mit einem anderen, dazu räumlich getrennten TE-Einzelwärmetauscher (6) über eine große Anzahl metallischer Leiter verbunden in Reihe geschaltet ist.

2.  Vorrichtung nach Anspruch 1, wobei die im Innenteil (1) und Außenteil (2) spiegelbildlich angeordneten TE-Gesamtwärmeaustauscher (5) ansonsten baugleich sind und aus einer Vielzahl TE-Einzelwärmeaustauscher (6) bestehen.

3.  Vorrichtung nach Anspruch 1 oder 2, wobei die den jeweils TE-Gesamtwärmeaustauscher (5) bildenden TE-Einzelwärmeaustauscher (6) in modularer Anordnung waagrecht, senkrecht oder hintereinander angeordnet sind.

4.  Vorrichtung nach einem der vorhergehenden Ansprüche, wobei die TE-Einzelwärmeaustauscher (6) mit elektrisch isolierenden mechanischen Abstandshaltern (14) versehen sind.

5.  Vorrichtung nach einem der vorhergehenden Ansprüche, wobei die Luft mittels Ventilation (20) über die Tropfwassersammelschale (23) durch das an dieser Stelle offene Gehäuse senkrecht über den TE - Gesamtwärmeaustauscher (5) nach oben und im Außenteil (2) über den TE-Gesamtwärmeaustauscher (5) waagrecht geführt wird.

6.  Vorrichtung nach einem der vorhergehenden Ansprüche, wobei die TE - Einzelwärmeaustauscher (6) jeweils aus zwei parallelen metallischen Leiterplatten (7, 8) zwischen denen in Stromrichtung gesehen in großer Zahl N-P dotierte Thermopaare (9, 10) senkrecht und damit parallel angeordnet sind.

7.  Vorrichtung nach einem der vorhergehenden Ansprüche, wobei die metallischen Leiterplatten (7, 8) aus elektrisch und thermisch gut leitendem Material (z.B. Kupfer) bestehen.

8.  Vorrichtung nach einem der vorhergehenden Ansprüche, wobei die Thermopaare (9,10) in Stromrichtung gleichartig z.B. alle N-P bzw. alle P-N dotiert sind.

9. Vorrichtung nach einem der vorhergehenden Ansprüche, wobei die stirnseitigen Berührungsflächen der modular angeordneten TE-Einzelwärmeaustauscher (6) sowie die komplette Abgrenzung (16) des TE-Gesamtwärmeaustauscher (5) gegenüber dem Gehäuse (3) mit elektrisch und wärmeisolierendem druckfesten Material (19) versehen ist.

10. Vorrichtung nach einem der vorhergehenden Ansprüche, wobei die metallische Leiterplatte (7) komplett aus N dotierten und die Verbindung zwischen den metallischen Leiterplatten aus P dotierten Halbleitermaterial, die metallische Leiterplatte (8) aus z.B. Kupfer besteht.

11. Vorrichtung nach einem der vorhergehenden Ansprüche, wobei die metallische Leiterplatte (7) komplett aus P dotierten und die Verbindung zwischen den metallischen Leiterplatten aus N dotierten Halbleitermaterial, die metallische Leiterplatte (8) in z.B. Kupfer besteht.

12. Vorrichtung nach einem der vorhergehenden Ansprüche, wobei die Leiterplatte (7) komplett aus N dotierten und die Verbindung zwischen den Leiterplatten z.B. aus Kupfer, die metallische Leiterplatte (8) komplett aus P-dotierten Halbleitermaterial besteht.

13. Vorrichtung nach einem der vorhergehenden Ansprüche, wobei die metallische Leiterplatte (7) und (8) komplett aus z.B. Kupfer und die Verbindung zwischen den Leiterplatten (7) und (8) aus einem N-P dotierten Thermopaar besteht.

14. Vorrichtung nach einem der vorhergehenden Ansprüche, wobei die nach innen gewandten Flächen der metallischen Leiterplatten aus beschichtetem Halbleitermaterial und die nach außen zugewandten Flächen ganz oder teilweise z.B. aus Kupfer in Sandwich-Ausführung ausgeführt sind.

## Claims

1. Device for generating cold and power according to the Peltier principle, which has a heat-absorbing and a heat-dissipating part, wherein the formation of thermoelectric TE individual heat exchangers (6), which are combined to form at least two TE total heat exchangers (5), in each case a heat-absorbing and a heat-dissipating TE total heat exchanger (5), which are spatially separated from one another, wherein the heat-absorbing TE total heat exchanger (5) is arranged in an inner part (1) of the device and the heat-dissipating TE total heat exchanger (5) is arranged in an outer part (2) of the device, and each TE individual heat exchanger (6) has printed circuit boards (7, 8) which are positioned in parallel and at distance from each other, having N-P or P-N doped thermocouples, as seen in the direction of current, which are electrically connected in parallel, wherein each TE individual heat exchanger (6) is connected in series with another TE individual heat exchanger (6), spatially separated therefrom, via a large number of metallic conductors.

2. Device according to claim 1, wherein the TE total heat exchangers (5) arranged in mirror image in the inner part (1) and outer part (2) are otherwise identical in construction and consist of a plurality of TE individual heat exchangers (6).

3. Device according to claim 1 or 2, wherein the TE individual heat exchangers (6) forming the respective TE overall heat exchanger (5) are arranged horizontally, vertically or one behind the other in a modular arrangement.

4. Device according to one of the preceding claims, wherein the TE individual heat exchangers (6) are provided with electrically insulating mechanical spacers (14).

5. Device according to one of the preceding claims, wherein the air is guided by means of ventilation (20) via the drip water collection tray (23) through the housing, which is open at this point, vertically upwards via the TE total heat exchanger (5) and horizontally in the outer part (2) via the TE total heat exchanger (5).

6. Device according to one of the preceding claims, wherein the TE individual heat exchangers (6) each consist of two parallel metallic printed circuit boards (7, 8) between which, as viewed in the direction of current, large numbers of N-P doped thermocouples (9, 10) are arranged vertically and thus in parallel.

7. Device according to one of the preceding claims, wherein the metallic conductor plates (7, 8) consist of electrically and thermally well conducting material (e.g. copper).

8. Device according to one of the preceding claims, wherein the thermocouples (9, 10) are doped in the same way in the direction of current, e.g. all N-P or all P-N.

9. Device according to one of the preceding claims, wherein the end-face contact surfaces of the modularly arranged TE individual heat exchangers (6) and the complete boundary (16) of the TE overall heat exchanger (5) with respect to the housing (3) are provided with electrically and thermally insulating pressure-resistant material (19).

10. Device according to one of the preceding claims, wherein the metallic printed circuit board (7) consists entirely of N-doped semiconductor material and the connection between the metallic printed circuit boards consists of P-doped semiconductor material, the metallic printed circuit board (8) consists of e.g. copper.

11. Device according to one of the preceding claims, wherein the metallic printed circuit board (7) consists entirely of P-doped semiconductor material and the connection between the metallic printed circuit boards consists of N-doped semiconductor material, the metallic printed circuit board (8) made in e.g. copper.

12. Device according to one of the preceding claims, wherein the printed circuit board (7) consists entirely of N-doped semiconductor material and the connection between the printed circuit boards consists of e.g. copper, the metallic printed circuit board (8) consists entirely of P-doped semiconductor material.

13. Device according to one of the preceding claims, wherein the metallic circuit board (7) and (8) consists entirely of e.g. copper and the interconnection between the circuit boards (7) and (8) consists of an N-P doped thermocouple.

14. Device according to one of the preceding claims, wherein the inwardly facing surfaces of the metallic circuit boards are made of coated semiconductor material and the outwardly facing surfaces are made entirely or partially of e.g. copper in sandwich design.

## Revendications

1. Dispositif pour la production de froid et d'électricité selon le principe de Peltier comprenant une partie qui reçoit de la chaleur et une partie qui émet de la chaleur, dans lequel, en formant des échangeurs de chaleur thermoélectriques TE individuels (6) regroupés dans au moins deux échangeurs de chaleur TE groupés (5), à savoir un échangeur de chaleur TE groupé recevant de la chaleur et un échangeur de chaleur TE groupé (5) émettant de la chaleur qui sont séparés l'un de l'autre dans l'espace, l'échangeur de chaleur TE groupé (5) recevant la chaleur étant disposé dans une partie intérieure (1) du dispositif et l'échangeur de chaleur TE groupé (5) émettant la chaleur dans une partie extérieure (2) du dispositif, et chaque échangeur de chaleur TE individuel (6) présente des plaquettes de circuits (7, 8) disposées parallèlement et à distance les unes des autres avec des thermocouples dopés N-P ou P-N dans le sens du courant qui sont montés électriquement en parallèle, chaque échangeur de chaleur TE individuel (6) étant monté en série avec un autre échangeur de chaleur TE individuel (6) séparé de lui dans l'espace par un grand nombre de conducteurs métalliques.

2. Dispositif selon la revendication 1, dans lequel les échangeurs de chaleur TE groupés (5) disposés en miroir dans la partie intérieure (1) et la partie extérieure (2) sont par ailleurs de construction identique et se composent d'un grand nombre d'échangeurs de chaleur TE individuels (6).

3. Dispositif selon la revendication 1 ou 2, dans lequel les échangeurs de chaleur TE individuels (6) composant chaque échangeur de chaleur TE groupé (5) sont disposés selon une disposition modulaire à l'horizontale, à la verticale ou à la suite les uns des autres.

4. Dispositif selon l'une des revendications précédentes, dans lequel les échangeurs de chaleur TE individuels (6) sont munis d'espaceurs (14) isolants électriques.

5. Dispositif selon l'une des revendications précédentes, dans lequel l'air est acheminé verticalement vers le haut par-dessus les échangeurs de chaleur TE groupés (5) au moyen d'une ventilation (20) au-dessus du bac collecteur de gouttes d'eau (23) à travers le boîtier ouvert à cet endroit et horizontalement par-dessus les échangeurs de chaleur TE groupés (5) dans la partie extérieure (2).

**6.** Dispositif selon l'une des revendications précédentes, dans lequel les échangeurs de chaleur TE individuels (6) se composent de deux plaquettes de circuits métalliques (7, 8) parallèles, entre lesquelles un grand nombre de thermocouples (9, 10) dopés N-P dans le sens de l'écoulement sont disposés verticalement et ainsi parallèlement.

**7.** Dispositif selon l'une des revendications précédentes, dans lequel les plaquettes de circuits métalliques (7, 8) se composent d'un matériau bon conducteur électrique et thermique (par exemple de cuivre).

**8.** Dispositif selon l'une des revendications précédentes, dans lequel les thermocouples (9, 10) sont tous dopés, par exemple, N-P ou tous dopés P-N dans le sens du courant.

**9.** Dispositif selon l'une des revendications précédentes, dans lequel les surfaces frontales de contact des échangeurs de chaleur TE individuels (6) et toute la délimitation (16) de l'échangeur de chaleur TE groupé (5) vis-à-vis du boîtier (3) sont munies d'un matériau résistant à la pression, isolant électrique et isolant thermique (19).

**10.** Dispositif selon l'une des revendications précédentes, dans lequel la plaquette de circuits métallique (7) se compose entièrement de matériau semi-conducteur dopé N et la connexion entre les plaquettes de circuits métalliques de matériau semi-conducteur dopé P et la plaquette de circuits métallique (8) se compose, par exemple, de cuivre.

**11.** Dispositif selon l'une des revendications précédentes, dans lequel la plaquette de circuits métallique (7) se compose entièrement de matériau semi-conducteur dopé P et la connexion entre les plaquettes de circuits métalliques de matériau semi-conducteur dopé N et la plaquette de circuits métallique (8) se compose, par exemple, de cuivre.

**12.** Dispositif selon l'une des revendications précédentes, dans lequel la plaquette de circuits (7) se compose entièrement de matériau semi-conducteur dopé N et la connexion entre les plaquettes de circuits composées, par exemple, de cuivre et la plaquette de circuits métallique (8) se compose entièrement de matériau semi-conducteur dopé P.

**13.** Dispositif selon l'une des revendications précédentes, dans lequel les plaquettes de circuits métalliques (7) et (8) se composent entièrement, par exemple, de cuivre et la connexion entre les plaquettes de circuit (7) et (8) se compose d'un thermocouple dopé N-P.

**14.** Dispositif selon l'une des revendications précédentes, dans lequel les surfaces tournées vers l'intérieur des plaquettes de circuits métalliques se composent de matériau semi-conducteur revêtu et les surfaces tournées vers l'extérieur se composent entièrement ou en partie, par exemple, de cuivre en construction sandwich.

# Fig. 1

# Fig. 2

# Fig. 3

Fig. 4

# Fig. 5

Einzelheit "A"

Einzelheit "E"

Einzelheit "B"

Einzelheit "F"

Einzelheit "C"

Einzelheit "G"

Einzelheit "D"

N dotiert

P dotiert

z. B. Kupfer

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 103000799 A
- JP 2005228915 A
- US 2001013224 A1
- US 5966939 A
- EP 3336909 A1